# EUROPÄISCHE PATENTANMELDUNG

(11) **EP 0 905 824 A2**
(43) Veröffentlichungstag der Anmeldung: **31.03.1999**
(21) Anmeldenummer: 98113570.0
(22) Anmeldetag: 20.07.1998
(51) Int. Cl.: H01R 23/70

(54) **Elektrischer Verbinder**

(30) Priorität: 30.09.1997 DE 19743251
(71) Anmelder: SIEMENS AKTIENGESELLSCHAFT, 80333 München (DE)
(72) Erfinder: Longueville, Jacques, 8020 Oostkamp (BE)

(57) **Zusammenfassung**

Es wird ein elektrischer Verbinder zur Montage auf einer Leiterplatte (2) beschrieben, mit Anschlußelementen (12), durch welche der elektrische Verbinder zumindest elektrisch mit der Leiterplatte verbindbar ist, und mit einer Verankerungsvorrichtung (13), durch welche der elektrische Verbinder mechanisch mit der Leiterplatte verbindbar ist. Der beschriebene elektrische Verbinder zeichnet sich dadurch aus, daß die Verankerungsvorrichtung eine Vielzahl von nebeneinander angeordneten, zum Verlöten mit der Leiterplatte ausgelegten Verankerungselementen (131) umfaßt.

## Beschreibung

Die vorliegende Erfindung betrifft eine Vorrichtung gemäß dem Oberbegriff des Patentanspruchs 1, d.h. einen elektrischen Verbinder zur Montage auf einer Leiterplatte, mit Anschlußelementen, durch welche der elektrische Verbinder zumindest elektrisch mit der Leiterplatte verbindbar ist, und mit einer Verankerungsvorrichtung, durch welche der elektrische Verbinder mechanisch mit der Leiterplatte verbindbar ist.

Elektrische Verbinder dieser Art sind in einer Vielzahl von Ausführungsformen bekannt. Die Anschlußelemente, durch welche die elektrischen Verbinder zumindest elektrisch mit der Leiterplatte verbunden werden, sind dabei häufig Anschlußelemente, die dazu ausgelegt sind, nach dem SMT-Lötverfahren mit der Leiterplatte verlötet zu werden.

Insbesondere bei derart ausgebildeten, aber auch bei andersartigen Anschlußelementen besteht die Gefahr, daß diese sich bei einer starken mechanischen Beanspruchung des elektrischen Verbinders (bei einer Bewegung des elektrischen Verbinders relativ zur Leiterplatte) von der Leiterplatte ablösen, wodurch der elektrische Kontakt zu dieser zeitweise oder dauerhaft unterbrochen oder zumindest verschlechtert wird.

Zur Vermeidung dessen sind die elektrischen Verbinder zum Teil mit Verankerungsvorrichtungen ausgestattet, durch welche sie mechanisch so fest mit der Leiterplatte verbunden werden sollen, daß eine Bewegung der elektrischen Verbinder relativ zur Leiterplatte ausgeschlossen oder zumindest erheblich eingeschränkt ist.

Ein Beispiel für eine derartige Verankerungsvorrichtung sind am elektrischen Verbinder vorgesehene Rasthaken, welche bei der Montage des elektrischen Verbinders auf die Leiterplatte mit zugeordneten Rastelementen der Leiterplatte (beispielsweise mit in der Leiterplatte vorgesehenen Ausnehmungen) verrasten. Derartige und andere bekannte Verankerungsvorrichtungen verbinden den elektrischen Verbinder und die Leiterplatte jedoch nicht vollkommen fest miteinander. Es ist immer ein gewisses Spiel vorhanden, wodurch Bewegungen des elektrischen Verbinders relativ zur Leiterplatte nicht gänzlich ausgeschlossen sind. Selbst sehr kleine Bewegungsfreiheiten können mit der Zeit zu einer Ablösung der Anschlußelemente des elektrischen Verbinders von der Leiterplatte führen. Dies ist ein Nachteil, den es zu beseitigen gilt.

Der vorliegenden Erfindung liegt daher die Aufgabe zugrunde, den elektrischen Verbinder gemäß dem Oberbegriff des Patentanspruchs 1 derart weiterzubilden, daß dieser derart mit der Leiterplatte verbindbar ist, daß die elektrische Verbindung zwischen dem elektrischen Verbinder und der Leiterplatte beeinträchtigende Bewegungen des elektrischen Verbinders relativ zur Leiterplatte zuverlässig und dauerhaft weitestgehend ausgeschlossen sind.

Diese Aufgabe wird erfindungsgemäß durch die im kennzeichnenden Teil des Patentanspruchs 1 beanspruchten Merkmale gelöst.

Demnach ist vorgesehen, daß die Verankerungsvorrichtung eine Vielzahl von nebeneinander angeordneten, zum Verlöten mit der Leiterplatte ausgelegten Verankerungselementen umfaßt.

Die Auslegung der Verankerungsvorrichtung zum Verlöten mit der Leiterplatte ermöglicht die Herstellung einer spielfreien mechanischen Verbindung zwischen dem elektrischen Verbinder und der Leiterplatte.

Die Unterteilung der insgesamt im wesentlichen steifenartigen Verankerungsvorrichtung in eine Vielzahl einzelner Verankerungselemente ermöglicht dabei eine zuverlässigere mechanische Verbindung zwischen dem elektrischen Verbinder und der Leiterplatte als wenn die Verankerungsvorrichtung als ein zusammenhängender Verankerungsstreifen ausgebildet wäre.

Durch die vielen kleinen Lötstellen, die durch das Verlöten der einzelnen Verankerungselemente mit der Leiterplatte entstehen, kann die insgesamt im wesentlichen streifenartige Verankerungsvorrichtung über ihre gesamte Länge gleichermaßen fest mit der Leiterplatte verbunden werden; lokal schwächere Verbindungen wie sie bei der Verwendung eines zusammenhängenden Verankerungsstreifens auftreten können, weil
- sich innerhalb der dann sehr großen Lötfläche während des Lötvorganges die Lötpaste umverteilt (in nicht vorhersagbarer Weise lokal zusammenfließt) und/oder
- sich der Verankerungsstreifen während und nach dem Löten anders ausdehnt und zusammenzieht als die Leiterplatte,
sind dadurch ausgeschlossen.

Es wurde mithin ein elektrischer Verbinder geschaffen, welcher derart mit der Leiterplatte verbindbar ist, daß die elektrische Verbindung zwischen dem elektrischen Verbinder und der Leiterplatte beeinträchtigende Bewegungen des elektrischen Verbinders relativ zur Leiterplatte zuverlässig und dauerhaft weitestgehend ausgeschlossen sind.

Die Vielzahl der Verankerungselemente verleiht der Verankerungsvorrichtung andererseits aber eine Beweglichkeit, die es ihr in gewissem Umfang ermöglicht, gegebenenfalls auftretenden Bewegungen (beispielsweise Vibrationen oder thermisch bedingten Dehnungen oder Schrumpfungen) des elektrischen Verbinders und/oder der Leiterplatte zu folgen, ohne den elektrischen Verbinder, die Leiterplatte und/oder die Lötstellen zu beschädigen. Umgekehrt führen auch thermisch bedingte oder durch andere Umstände verursachte Bewegungen, Dehnungen oder Schrumpfungen der Verankerungselemente selbst nicht gleich zu Beschädigungen des elektrischen Verbinders, der Leiterplatte und/oder der Lötstellen. Der elektrische Verbinder und die Verankerungselemente desselben können folglich - obgleich sie mechanisch äußerst fest mit der Leiterplatte verbindbar sind - Bewegungen ausführen, deren Unterbindung den elektrischen Kontakt zwischen dem elektrischen Verbinder und der Leiterplatte beeinträchtigen (schwächen oder unterbrechen) könnte.

Vorteilhafte Weiterbildungen der Erfindung sind Gegenstand der Unteransprüche.

Die Erfindung wird nachfolgend anhand eines Ausführungsbeispiels unter Bezugnahme auf die Zeichnung näher erläutert. Es zeigen
- Figur 1: eine perspektivische Ansicht eines Ausführungsbeispiels des neuartigen elektrischen Verbinders,
- Figur 2: eine perspektivische Ansicht eines einzelnen Verankerungselements des elektrischen Verbinders gemäß Figur 1,
- Figur 3: eine perspektivische Ansicht mehrerer nebeneinander angeordneter Verankerungselemente gemäß Figur 2, und
- Figur 4: eine Draufsicht auf eine zur Montage des elektrischen Verbinders gemäß Figur 1 ausgelegte Leiterplatte.

Der im folgenden näher beschriebene elektrische Verbinder ist in den Figuren mit dem Bezugszeichen 1 bezeichnet. Er ist dazu ausgelegt, stumpf, also beispielsweise unter Verwendung eines SMT-Lötverfahrens auf die Oberfläche einer Leiterplatte 2 gelötet zu werden. Im auf der Leiterplatte 2 montierten Zustand dient er dazu, diese Leiterplatte mit einer in den Figuren nicht gezeigten anderen Leiterplatte zu verbinden; im betrachteten Beispiel ist die Leiterplatte 2 (beispielsweise eine sogenannte Baugruppen-Leiterplatte) dazu ausgelegt, im wesentlichen senkrecht auf die andere Leiterplatte (beispielsweise eine sogenannte Rückwand-Leiterplatte) aufgesteckt zu werden. Allerdings ist die Verwendung des elektrischen Verbinders nicht auf solche Fälle beschränkt. Er kann auch für andersartige Verbindungen von zwei oder mehreren Leiterplatten verwendet werden und zusätzlich oder alternativ auch zum Anschluß eines Kabels oder sonstiger Einrichtungen ausgelegt sein.

Der elektrische Verbinder 1 ist im betrachteten Beispiel ein Steckverbinder. Die Erfindung läßt sich jedoch auch bei andersartigen elektrischen Verbindern, beispielsweise bei Andruckverbindern zur Kontaktierung von Oberflächenkontakten etc. anwenden. Der elektrische Verbinder kann unter anderem auch als Nullkraftsteckverbinder oder schwimmender Verbinder ausgebildet sein oder sonstige besonderen Bauformen aufweisen.

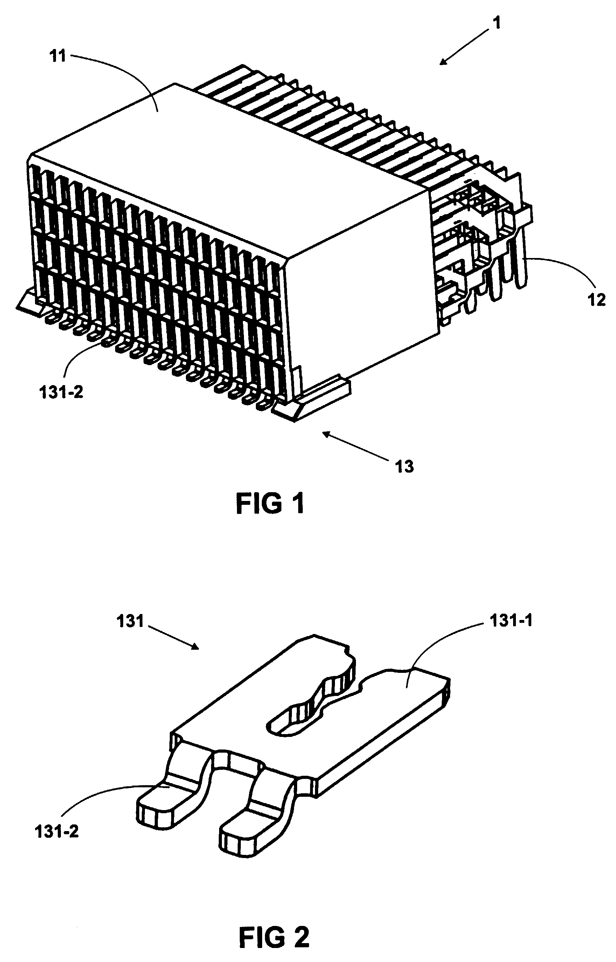

Wie aus der Figur 1 ersichtlich ist, umfaßt der elektrische Verbinder 1 ein Gehäuse 11, eine Vielzahl von Anschlußelementen 12 und Verankerungsvorrichtung 13.

Die Anschlußelemente 12 sind dazu ausgelegt, stumpf, also beispielsweise unter Verwendung eines SMT-Lötverfahrens auf die Oberfläche der Leiterplatte 2 gelötet zu werden; sie dienen insbesondere zur elektrischen Verbindung des elektrischen Verbinders 1 mit der Leiterplatte 2, sorgen aber zugleich auch für eine gewisse, freilich nur gering belastbare mechanische Verbindung zwischen dem elektrischen Verbinder 1 und der Leiterplatte 2.

Die Verankerungsvorrichtung 13 ist ebenfalls dazu ausgelegt, stumpf, also beispielsweise unter Verwendung eines SMT-Lötverfahrens auf die Oberfläche der Leiterplatte 2 gelötet zu werden; sie dient zur mechanischen Verbindung des elektrischen Verbinders 1 mit der Leiterplatte 2.

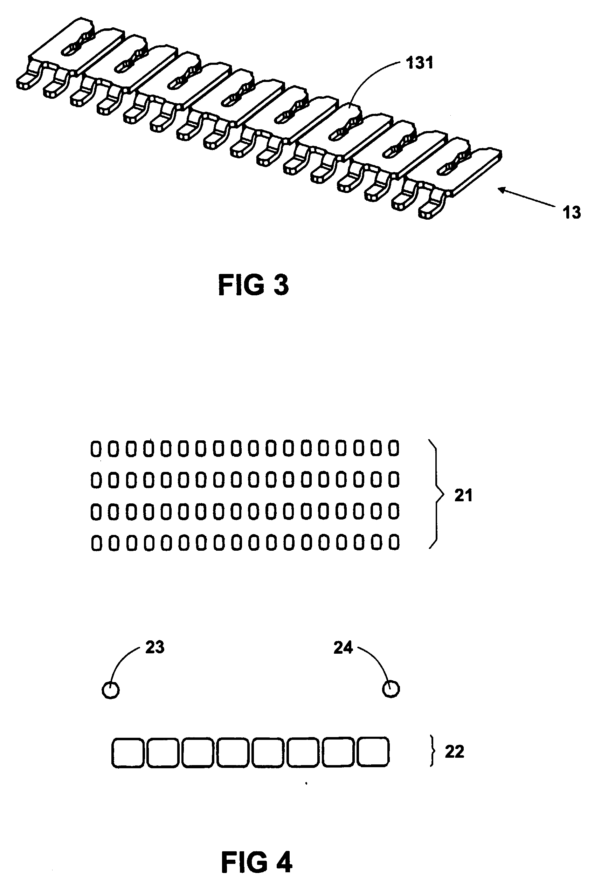

Die Verankerungsvorrichtung 13 umfaßt eine Vielzahl von nebeneinander angeordneten Verankerungselementen 131, von welchen ein einzelnes in Figur 2 und mehrere in einer Reihe nebeneinander angeordnete in Figur 3 veranschaulicht sind.

Wie insbesondere aus der Figur 2 ersichtlich ist, bestehen die Verankerungselemente aus einem Befestigungsabschnitt 131-1, und zwei (gegebenenfalls auch mehr oder weniger) als Lötfahnen ausgebildeten fingerartigen Fortsätzen 131-2.

Die Befestigungsabschnitte 131-1 sind im betrachteten Beispiel plattenartige Abschnitte mit U-förmigem Grundriß; sie sind dazu ausgelegt, an der der Leiterplatte 2 zugewandten Seite des Gehäuses 11 an diesem befestigt oder in dieses integriert zu werden.

Die Fortsätze 132-2, genauer gesagt deren freie Endabschnitte sind dazu ausgelegt, mit der Leiterplatte 2 verlötet zu werden.

Die Verankerungsvorrichtung 13 wird durch eine wie in Figur 3 beispielhaft veranschaulichte Aneinanderreihung einer Vielzahl von Verankerungselementen 131 gemäß Figur 2 gebildet. Die einzelnen Verankerungselemente 131 können dabei direkt aneinanderstoßen (einander berühren) oder mehr oder weniger große Abstände voneinander aufweisen. Zu beachten ist jedoch, daß die Verankerungselemente 131 durch die Aneinanderreihung nicht etwa zu einem langen starren Verankerungsstreifen kombiniert werden, sondern unabhängig voneinander wirkende und reagierende Einzel-Verankerungselemente bleiben; es wird sich daher in der Regel als vorteilhaft erweisen, wenn benachbarte Verankerungselemente zumindest geringfügig voneinander beäbstandet sind.

Durch die Aneinanderreihung der Verankerungselemente 131 erhält man eine Vielzahl von nebeneinander liegenden Lötfahnen 131-2, die einzeln mit der Leiterplatte verlötet werden können.

Die Leiterplatte 2, auf welcher der wie beschrieben ausgebildete elektrische Verbinder 1 zu montieren ist, ist in Figur 4 ausschnittsweise in der Draufsicht dargestellt.

Wie aus der Figur 4 ersichtlich ist, umfaßt die Leiterplatte 2 in dem Bereich, in dem der elektrische Verbinder zu montieren ist, eine erste Gruppe 21 von zum Löten nach einem SMT-Verfahren ausgelegten Lötpunkten, eine zweite Gruppe 22 von zum Löten nach einem SMT-Verfahren ausgelegten Lötpunkten, und Ausnehmungen 23 und 24.

Die erste Gruppe 21 von Lötpunkten ist zum Anlöten der Anschlußelemente 12 bestimmt, die zweite Gruppe 22 von Lötpunkten zum Anlöten der Lötfahnen 132-2 der Verankerungselemente 131, und die Ausnehmungen 23 und 24 zur Aufnahme von in den Figuren nicht gezeigten Stiften des elektrischen Verbinders für die bestimmungsgemäße Positionierung desselben auf der Leiterplatte.

Im bestimmungsgemäß auf der Leiterplatte montierten Zustand des elektrischen Verbinders befindet sich dieser zwischen der ersten Gruppe 21 von Lötpunkten und der zweiten Gruppe 22 von Lötpunkten.

Die Anschlußelemente 12 und die Verankerungsvorrichtung 13 sind im betrachteten Beispiel an gegenüberliegenden Seiten des elektrischen Verbinders angeordnet. Dies erweist sich als besonders vorteilhaft, weil ein Anheben des elektrischen Verbinders an der den Anschlußelementen 12 gegenüberliegenden Seite desselben besonders leicht und schnell ein Aufreißen der Lötverbindungen zwischen den Anschlußelementen 12 und der ersten Gruppe 21 von Lötpunkten bewirken kann. Nichtsdestotrotz können die Anschlußelemente 12 und die Verankerungsvorrichtung 13 auch andere Relativlagen aufweisen.

Bedingt durch die Vielzahl der einzelnen Lötstellen, über welche die Verankerungsvorrishtung mit der Leiterplatte verbunden wird, kommt eine zuverlässig und dauerhaft feste Verbindung zwischen dem elektrischen Verbinder und der Leiterplatte zustande. Einerseits kann nämlich jede einzelne Lötstelle perfekt ausgebildet werden, so daß über die gesamte Länge der (insgesamt im wesentlichen streifenartig ausgebildeten) Verankerungsvorrichtung eine gleichbleibend gute Verbindung zwischen dieser und der Leiterplatte erzielt werden kann, und andererseits sind diese Lötstellen von allen Seiten belastbar, denn die Lötpaste kann sich an den Fortsätzen 131-2 der Verankerungselemente 131 allseits entlangziehen und rundum gleichmäßig verteilen.

Dieser positive Effekt wird verstärkt, wenn für die Vielzahl der Verankerungselemente nicht etwa nur eine zusammenhängende große Lötfläche auf der Leiterplatte vorgesehen wird, sondern - wie beispielhaft in Figur 4 veranschaulicht - mehrere einzelne Lötinseln; im betrachteten Beispiel ist jedem Verankerungselement eine eigene Lötinsel zugeordnet. Dann kann zusätzlich verhindert werden, daß die Lötpaste beim Lötvorgang aus einzelnen Bereichen abläuft und sich an anderen Stellen sammelt, was eine lokal unterschiedlich feste Verbindung des elektrischen Verbinders (dessen Verankerungsvorrichtung) und der Leiterplatte zur Folge hätte.

Die wie beschrieben erfolgende Ausbildung der Verankerungsvorrichtung und deren spielfreie Verbindung mit der Leiterplatte ermöglicht es, die Verbindungen zwischen den Anschlußelementen 12 und der Leiterplatte 2 beanspruchende Relativbewegungen zwischen dem elektrischen Verbinder und der Leiterplatte im wesentlich völlig zu unterbinden.

Andererseits ist die Verbindung zwischen der Verankerungsvorrichtung und der Leiterplatte wegen der Unterteilung der Verankerungsvorrichtung in viele einzelne Verankerungselemente nicht völlig starr, so daß in gewissem Umfang bestimmte Relativbewegungen zwischen dem elektrischen Verbinder und der Leiterplatte möglich sind. Insbesondere können die einzelnen Verankerungselemente im wesentlichen unabhängig voneinander gegebenenfalls auftretenden Bewegungen (beispielsweise Vibrationen oder thermisch bedingten Dehnungen oder Schrumpfungen) des elektrischen Verbinders und/oder der Leiterplatte folgen. Umgekehrt können der elektrische Verbinder und die Leiterplatte thermisch bedingten oder durch andere Umstände verursachten Bewegungen, Dehnungen oder Schrumpfungen der Verankerungselemente lokal folgen, wodurch größere Spannungen innerhalb des elektrischen Verbinders und/oder der Leiterplatte vermieden werden können. Dies ist wegen der verschiedenen Materialien, aus denen der elektrische Verbinder, dessen Verankerungsvorrichtung und die Leiterplatte bestehen bzw. - genauer gesagt - der unterschiedlichen Steifigkeit und dem unterschiedlichen thermischen Verhalten derselben ein sehr bedeutsamer Aspekt.

Der beschriebene elektrischer Verbinder unterbindet damit einerseits den elektrischen Kontakt zwischen den Anschlußelementen und der Leiterplatte beeinträchtigende Relativbewegungen zwischen sich selbst und der Leiterplatte, läßt aber andererseits solche Relativbewegungen zu, deren Unterbindung den elektrischen Kontakt zwischen den Anschlußelementen und der Leiterplatte beeinträchtigen könnte.

## Patentansprüche

1. Elektrischer Verbinder zur Montage auf einer Leiterplatte (2), mit Anschlußelementen (12), durch welche der elektrische Verbinder zumindest elektrisch mit der Leiterplatte verbindbar ist, und mit einer Verankerungsvorrichtung (13), durch welche der elektrische Verbinder mechanisch mit der Leiterplatte verbindbar ist,
**dadurch gekennzeichnet**,
daß die Verankerungsvorrichtung eine Vielzahl von nebeneinander angeordneten, zum Verlöten mit der Leiterplatte ausgelegten Verankerungselementen (131) umfaßt.

2. Elektrischer Verbinder nach Anspruch 1,
**dadurch gekennzeichnet**,
daß die Verankerungselemente (131) dazu ausgelegt sind, nach einem SMT-Lötverfahren mit der Leiterplatte (2) verlötet zu werden.

3. Elektrischer Verbinder nach Anspruch 1 oder 2,
**dadurch gekennzeichnet**,
daß die Verankerungselemente (131) einen oder mehrere als Lötfahnen ausgebildeten Fortsätze (132-2) umfassen.

4. Elektrischer Verbinder nach Anspruch 2,
**dadurch gekennzeichnet**,
daß die Verankerungselemente (131) an der im montierten Zustand der Leiterplatte zugewandten Seite des elektrischen Verbinders mit diesem verbunden sind.

5. Elektrischer Verbinder nach einem der vorhergehenden Ansprüche,
**dadurch gekennzeichnet**,
daß die Anschlußelemente (12) und die Verankerungselemente (131) dazu ausgelegt sind, an gegenüberliegenden Seiten des elektrischen Verbinders mit der Leiterplatte (2) verbunden zu werden.
